# EUROPEAN PATENT SPECIFICATION

(11) **EP 3 996 483 B1**
(45) Date of publication and mention of the grant of the patent: **31.07.2024**
(21) Application number: 21204447.3
(22) Date of filing: 25.10.2021
(51) Int. Cl.: H05K 13/04, H05K 13/08, G06F 11/07

(54) **ABNORMALITY PREDICTION DEVICE, FEEDING DEVICE, AND ABNORMALITY PREDICTION METHOD**
VORRICHTUNG ZUR VORHERSAGE VON ANOMALIEN, ZUFÜHRUNGSVORRICHTUNG UND VERFAHREN ZUR VORHERSAGE VON ANOMALIEN
DISPOSITIF DE PRÉDICTION D'ANOMALIE, DISPOSITIF D'ALIMENTATION ET PROCÉDÉ DE PRÉDICTION D'ANOMALIE

(30) Priority: 09.11.2020 JP 2020186542
(43) Date of publication of application: 11.05.2022
(73) Proprietor: FUJI Corporation, Chiryu-shi, Aichi 472-8686 (JP)
(72) Inventor: Uchida, Go, Chiryu, Aichi, 472-8686 (JP); Oike, Hiroshi, Chiryu, Aichi, 472-8686 (JP); Esaki, Hirotake, Chiryu, Aichi, 472-8686 (JP); Amano, Masafumi, Chiryu, Aichi, 472-8686 (JP); Sugiyama, Kenji, Chiryu, Aichi, 472-8686 (JP); Matsudaira, Masaki, Chiryu, Aichi, 472-8686 (JP)
(74) Representative: Grünecker Patent- und Rechtsanwälte PartG mbB

(56) References cited:
- EP-A1- 3 397 040
- US-A1- 2005 262 394
- US-A1- 2016 249 499

## Description

### Technical Field

The present specification discloses an abnormality prediction device, a feeding device, and an abnormality prediction method.

### Background Art

Conventionally, as a feeding device, there has been a tape feeder that intermittently feeds a tape on which a component is disposed. As devices regarding the tape feeder, for example, an imaging unit configured to image a component pickup section of the tape feeder, and a characteristic inspection device configured to measure a feeding position of the tape based on the image data and evaluate the characteristics of the tape feeder by ranking based on the measurement result have been proposed (see, for example, Patent Literature 1 and the like). In this device, the use of the feeder is made more rational by detecting the characteristic (individual difference) of the feeder. In addition, as such a feeding device, there has been proposed a device in which a feeder diagnosis is executed in a situation that is the same as or similar to a tape-attached state even though the tape is in a tape-unattached state in which the tape is not attached to the tape feeder by performing various feeder diagnoses while providing a torque load by sliding contact of a brake pad with a rotor of a tape feeding mechanism (see, for example, Patent Literature 2 and the like). In this device, it is assumed that diagnosis of the tape feeder can be performed satisfactorily and with high reliability.

US 2005/262394 A1 relates to failure diagnosis for a drive mechanism in a printer or similar image forming apparatus. In particular, the drive mechanism transmits a driving force using a motor and a gear. Sheet timing sensors detect conveyance times of a printing sheet in predetermined sections as an operation state signal. When a sheet passes at a time other than scheduled, it is judged that jamming has occurred. Sheet passing times are used for failure judgement. When sheet passing times are in normal ranges, failure prediction processing is performed. Failure diagnosis includes acquiring a sheet feed number indicating a number of times of conveyance of a printing sheet as history information.

### [Prior Art Document]

### Patent Literature

Patent Literature 1: JP-A-2009-123895
Patent Literature 2: JP-A-2009-302475

### Summary of the Invention

### [Technical Problem]

However, in Patent Literature 1 described above, the characteristic (individual difference) of the feeder is merely detected, and abnormality detection and abnormality prediction are not performed. In Patent Literature 2, although a diagnosis can be performed without using the tape approximating when the tape is used, it is difficult to detect the abnormality or predict the abnormality when the tape is actually used.

The present disclosure is made in view of such problems and a main object of the present disclosure is to provide an abnormality prediction device, a feeding device, and an abnormality prediction method in which it is possible to more appropriately predict an abnormality of a gear.

### [Solution to Problem]

The present disclosure employs the following means in order to achieve the main object described above.

An abnormality prediction device of the present disclosure, which is used in a feeding device including a driving section, a gear connected to the driving section, and a detection section configured to detect a position of a medium fed in accordance with driving of the gear, and intermittently feeding the medium, the abnormality prediction device including: a control section configured to acquire detection information regarding a feed amount of the medium based on the position of the medium detected over time by the detection section, decompose the acquired detection information into a trend component regarding a moving average of the gear, a cycle component based on a cycle of the gear, and a random component obtained by excluding the trend component and the cycle component, obtain an abnormality level of the gear based on the cycle component obtained by the decomposition, and output the obtained abnormality level.

In this abnormality prediction device, the detection information regarding the feed amount of the medium based on the position of the medium detected over time is decomposed into the trend component regarding the moving average of the gear, the cycle component based on the cycle of the gear, and the random component obtained by excluding the trend component and the cycle component. Then, the abnormality prediction device obtains the abnormality level of the gear based on the cycle component obtained by the decomposition, and outputs the obtained abnormality level. Since the cycle component obtained by decomposing the detection information is a component strongly affected by, for example, deterioration or wear of the gear, it is possible to more appropriately predict the abnormality of the gear. Here, the "medium" means a medium fed by a feeding device, for example, a printing medium such as paper is exemplified in a printing device, and a tape member for supplying a component is exemplified in a mounting device. The "abnormality of the gear" includes not only deterioration and wear of the gear, but also breakage and misalignment of a rotation shaft.

In the abnormality prediction device of the present disclosure, the control section may obtain a difference value between a maximum value and a minimum value of the cycle component in each predetermined period as the abnormality level. Since the value of the cycle component changes depending on a rotation cycle of the gear, in this abnormality prediction device, it is possible to more appropriately predict the abnormality of the gear by using the difference value of the cycle component.

In the abnormality prediction device of the present disclosure, the control section may acquire the detection information in which one or more of the position of the medium detected by the detection section, an actual measurement value of the feed amount obtained based on the position of the medium, and an error between the actual measurement value and a feed amount per step of intermittently feeding the medium is associated with a time when the position of the medium is detected. In this abnormality prediction device, the cycle component can be decomposed by using the position of the medium, the actual measurement value of the feed amount, the error of the feed amount, or the like.

In the abnormality prediction device of the present disclosure, the control section may obtain an accidental abnormality level of the gear based on a chronological change of the trend component obtained by the decomposition. In this abnormality prediction device, it is possible to more appropriately predict the abnormality regarding the gear also by using a component other than the cycle component.

In the abnormality prediction device of the present disclosure for obtaining the accidental abnormality level, the control section may obtain a difference value between a maximum value and a minimum value of the trend component in each predetermined period as the accidental abnormality level. Since the maximum value and the minimum value of the trend component may be caused by the accidental abnormality of the gear, in the abnormality prediction device, it is possible to appropriately predict the abnormality of the gear by using the difference value of the trend component.

A feeding device of the present disclosure including: a driving section; a gear connected to the driving section; a detection section configured to detect a position of a medium fed in accordance with driving of the gear; and any of the abnormality prediction devices described above. Since the feeding device includes any of the abnormality prediction devices described above, it is possible to obtain an effect according to an adopted mode.

An abnormality prediction method of the present disclosure executed by a computer and used in a feeding device which includes a driving section, a gear connected to the driving section, and a detection section configured to detect a position of a medium fed in accordance with driving of the gear, and intermittently feeds the medium, the abnormality prediction method including: (a) a step of acquiring detection information regarding a feed amount of the medium based on the position of the medium detected over time by the detection section; (b) a step of decomposing the detection information acquired in the step (a) into a trend component regarding a moving average of the gear, a cycle component based on a cycle of the gear, and a random component obtained by excluding the trend component and the cycle component; and (c) a step of obtaining an abnormality level of the gear based on the cycle component obtained by the decomposition in the step (b).

Similar to the abnormality prediction device described above, in this abnormality prediction method, it is possible to more appropriately predict the abnormality of the gear by using the cycle component strongly affected by, for example, deterioration or wear of the gear. In the abnormality prediction method, various aspects of the abnormality prediction devices described above may be employed, or steps of realizing each function of the abnormality prediction device described above may be added.

### [Brief Description of Drawings]

Fig. 1 is a schematic explanatory diagram illustrating an example of processing system 10.
Fig. 2 is an explanatory diagram illustrating an example of information stored in storage section 35.
Fig. 3 is an explanatory view illustrating an example of position detection of medium 12.
Fig. 4 is a flowchart illustrating an example of a medium feed processing routine.
Fig. 5 is an explanatory diagram illustrating an example of detected data and each separated component.
Fig. 6 is a flowchart illustrating an example of a deterioration abnormality prediction processing routine.
Fig. 7 is an explanatory diagram illustrating an example of abnormality level display screen 50.
Fig. 8 is a flowchart illustrating an example of an accidental abnormality detection processing routine.

### Description of Embodiments

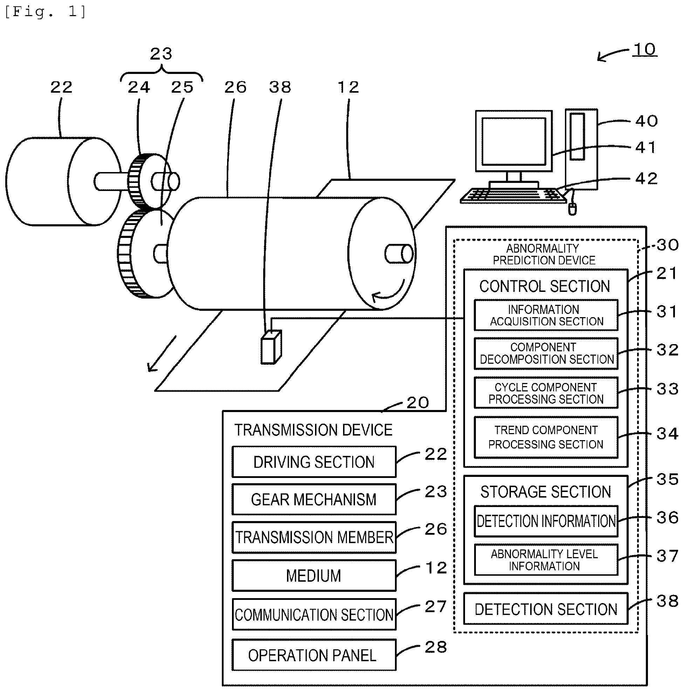

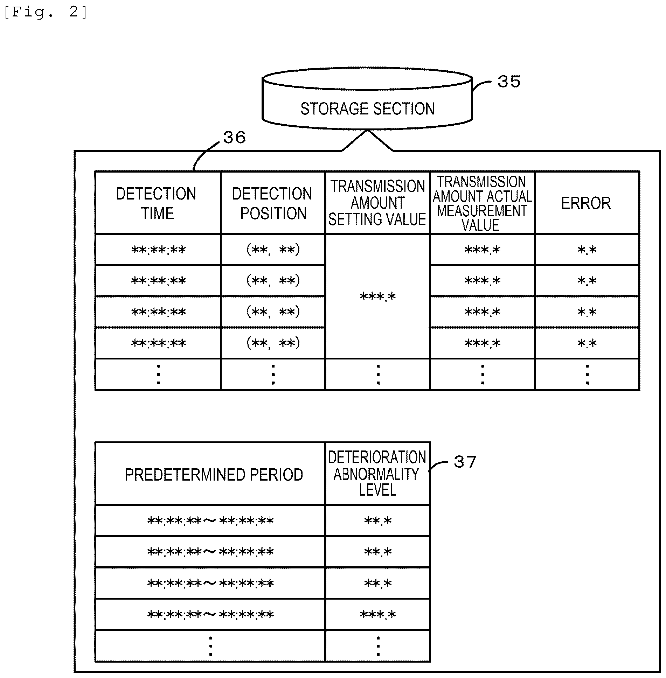

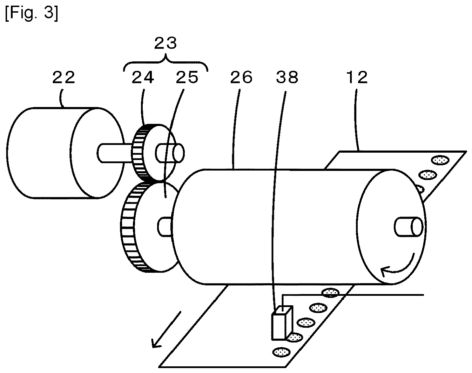

The present embodiment will be described below with reference to the drawings. Fig. 1 is a schematic explanatory diagram illustrating an example of processing system 10 according to the present disclosure. Fig. 2 is an explanatory diagram illustrating an example of information stored in storage section 35. Fig. 3 is an explanatory view illustrating an example of position detection of medium 12.

Processing system 10 is, for example, configured to intermittently feed a sheet-like member to perform predetermined processing. Processing system 10 may be, for example, a printing device that feeds a printing medium serving as medium 12 to perform printing processing on the printing medium. In addition, processing system 10 may be a mounting device that feeds a component attached to or accommodated in a tape-like mount paper as medium 12 and supply the component to a mounting head. Processing system 10 includes feeding device 20, abnormality prediction device 30, and management device 40.

Feeding device 20 performs a process for feeding medium 12. Feeding device 20 includes control section 21, driving section 22, gear mechanism 23, feeding member 26, communication section 27, and operation panel 28. Control section 21 is a controller, is configured as, for example, a microprocessor centered on CPU, and controls an entire device. In processing system 10, control section 21 performs control of feeding device 20 and control of abnormality prediction device 30, that is, is described as being shared, but abnormality prediction device 30 may be controlled by a separate control section, such as having another control section. Control section 21 includes a time management section (not illustrated) and is configured to be able to obtain a date and time when the processing is executed. Driving section 22 is a motor to which gear mechanism 23 is connected. Driving section 22 generates a driving force so as to intermittently feed medium 12, but may be, for example, a stepping motor which intermittently operates, or may intermittently drive and control a motor which continuously operates. Gear mechanism 23 delivers the rotational driving force of driving section 22 to feeding member 26, and has, for example, first gear 24 and second gear 25. First gear 24 is fixed to a rotation shaft of driving section 22. Second gear 25 is fixed to a rotation shaft of feeding member 26. First gear 24 meshes with second gear 25. Feeding member 26 is a feeding roller that abuts against a surface of medium 12 to feed medium 12. Communication section 27 is an interface for exchanging information with an external device such as management device 40. Operation panel 28 includes a display section that displays information and an operation section that performs an input operation input by an operator. Operation panel 28 may be, for example, a touch panel.

Abnormality prediction device 30 is a device for predicting and detecting an abnormality of feeding device 20. Abnormality prediction device 30 includes control section 21, storage section 35, and detection section 38. Control section 21 controls entire abnormality prediction device 30. Control section 21 has information acquisition section 31, component decomposition section 32, cycle component processing section 33, and trend component processing section 34 as functional blocks. These functional blocks are realized by executing a routine described later by control section 21. Information acquisition section 31 acquires detection information regarding feed amount based on the position of medium 12 detected over time by detection section 38. Component decomposition section 32 decomposes the acquired detection information into a trend component regarding a moving average of the gears included in gear mechanism 23, a cycle component based on the cycle of the gear, and a random component obtained by excluding the trend component and the cycle component. Cycle component processing section 33 obtains a deterioration abnormality level of the gears of gear mechanism 23 based on the cycle component obtained by the decomposition. Cycle component processing section 33 may obtain a difference value between the maximum value and the minimum value of the cycle component obtained in every predetermined period as the deterioration abnormality level. Trend component processing section 34 determines presence or absence of an occurrence of an accidental abnormality of the gear based on the chronological change of the trend component obtained by the decomposition. Trend component processing section 34 may obtain a difference value between the maximum value and the minimum value of the trend component in every predetermined period as the accidental abnormality level.

Storage section 35 is a large-capacity storage medium such as an HDD or a flash memory for storing various application programs and various data files. Although storage section 35 is also used as a storage section of feeding device 20, feeding device 20 may have another storage section. Storage section 35 stores detection information 36 and abnormality level information 37. As illustrated in Fig. 2, storage section 35 stores, for example, detection information 36 and abnormality level information 37. Detection information 36 is information in which one or more of the position of medium 12 detected by detection section 38, an actual measurement value of a feed amount obtained based on the position of medium 12, and an error between the feed amount per step for intermittently feeding medium 12 and the actual measurement value is associated with a time when the position of medium 12 is detected. Detection information 36 includes the chronological change of medium 12 fed by feeding device 20. Abnormality level information 37 is obtained by recording, over time, the deterioration abnormality level of the gears included in gear mechanism 23 obtained from detection information 36, and associates timing of a predetermined period with the deterioration abnormality level.

Detection section 38 is a sensor for detecting the position of medium 12, and may be, for example, a contact sensor or a non-contact sensor. The non-contact sensor may be, for example, a sensor that detects reflection of laser to detect the position of medium 12, or may be a sensor that detects the position of medium 12 by performing image processing by capturing an image of medium 12. As illustrated in Fig. 3, a marker may be provided on medium 12, and the position of medium 12 may be detected by recognizing a position of the marker.

Management device 40 is configured as a server that stores and manages a usage situation and a usage state of each device of processing system 10. Management device 40 includes display section 41 and input device 42. Display section 41 is a display for displaying a screen. Input device 42 includes a keyboard, a mouse, or the like inputted by the operator.

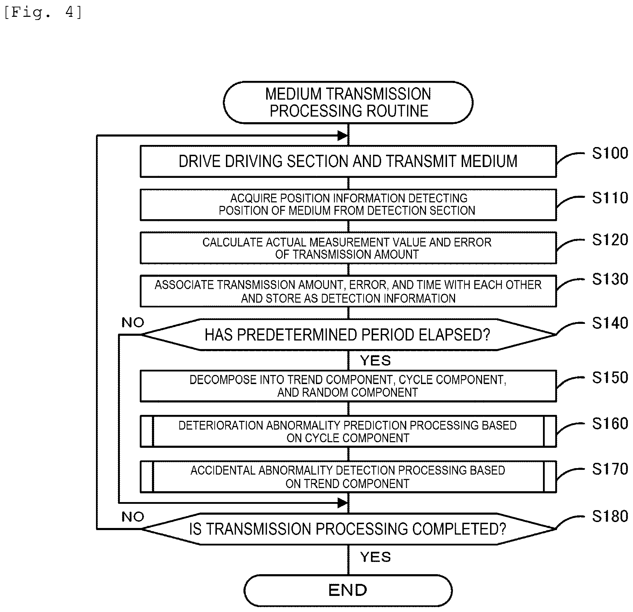

Next, in an operation of processing system 10 of the present embodiment configured as described above, first, processing in which feeding device 20 feeds medium 12 will be described. Fig. 4 is a flowchart illustrating an example of a medium feed processing routine executed by control section 21 of feeding device 20. This routine is stored in storage section 35 of feeding device 20 and is executed after an instruction is received to start of execution of the feed process of medium 12 by the operator. When this routine is started, control section 21 drives driving section 22 and feeds medium 12 (S100). In a case where driving section 22 is a stepping motor, if a set angle, for example, the number of steps is 60, first gear 24 rotates together with the rotation shaft of 360°/60=6°, and feeding member 26 rotates in accordance with the rotation to feed medium 12.

Next, control section 21 acquires the position information detecting the position of medium 12 from detection section 38 (S110), calculates an actual measurement value of the feed amount of medium 12, and calculates an error of the feed amount (S120). Detection section 38 detects the position of medium 12, for example, by image processing from a front end of medium 12 or a marker attached to medium 12, and outputs the position information to control section 21. Control section 21 obtains an actual measurement value of the feed amount from a difference between the positions detected this time and the previous time, and calculates an error from the difference between a set value of the feed amount determined in advance and the actual measurement value. Next, control section 21 causes storage section 35 to store the position information, the actual measurement value of the feed amount, and the error by being associated with the date and time when detecting them as detection information 36 (S130). As described above, control section 21 performs processing for updating the information regarding the position of medium 12 as detection information 36 over time in accordance with the feeding of medium 12.

Next, control section 21 determines whether a predetermined period has elapsed (S140). Control section 21 can make this determination, for example, everyday at startup, at a preset time, every time a preset time elapses, everytime medium 12 is fed by a preset number of steps, everytime the number of data reaches a preset number, or the like. The determination of the elapse of this period can be set in advance by the operator. Here, it is assumed that control section 21 determines that a predetermined period has elapsed when a preset number of pieces of data, for example, cycle 60× set value 10=600 pieces of data are newly accumulated. When the predetermined period has not elapsed, control section 21 determines whether all of the feed processing is completed (S180) and executes the processing in and after S100 when all of the feed processing is not completed.

On the other hand, in S140, when a predetermined period of time has elapsed, detection information 36 within the predetermined period is read, and processing for decomposing detection information 36 into the trend component, the cycle component, and the random component is performed (S150). In the decomposition processing, the trend component is a component based on a moving average of data of the number of gears of first gear 24 and second gear 25. The cycle component is a component based on an average of respective cycle elements in which the number of gears of first gear 24 and second gear 25 is the cycle. Control section 21 may separate the cycle component with respect to each gear of gear mechanism 23, such as the cycle component of first gear 24 and the cycle component of second gear 25. The random component is a component obtained by excluding the trend component and the cycle component from the position data (original data) in detection information 36. This component decomposition is implemented by, for example, a decompose function of a statistical function R, and may use a content specified in the "decomposition into a time-series component" described in an "R basic statistical function manual".

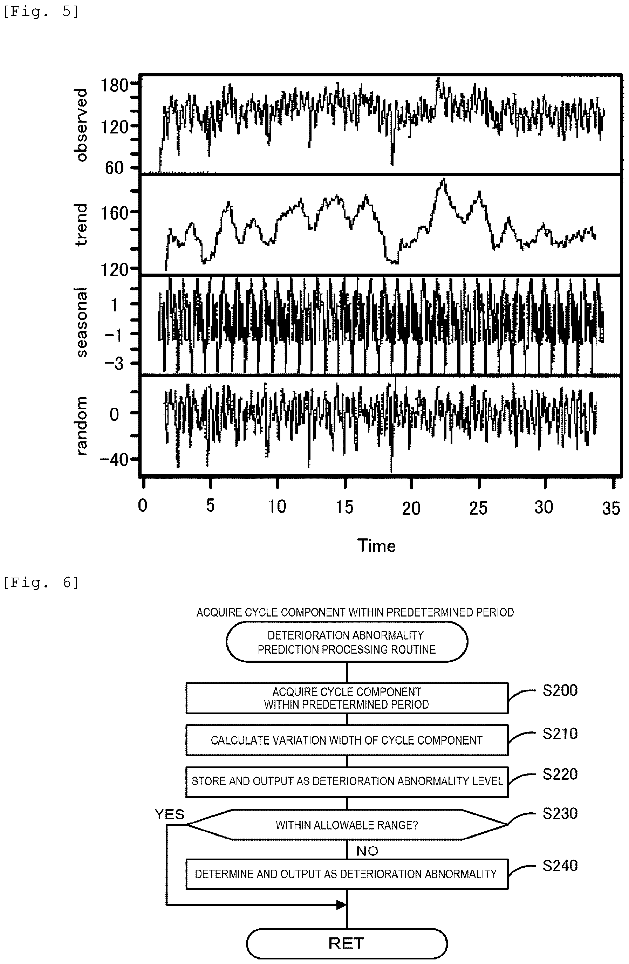

Fig. 5 is an explanatory diagram illustrating an example of the detected data and each separated component, in which a first stage is position data, a second stage is a trend component, a third stage is a cycle component, and a fourth stage is a random component in order from an upper stage. Fig. 5 illustrates an example in which 3000 pieces of position data are component-decomposed in cycles 10. The cycle component represents a variation corresponding to the cycle of the gear. In a case where the gear exhibits ideal behavior, the trend component, the cycle component, and the random component exhibit flat lines. When deterioration such as wear occurs in the gear, a variation corresponding thereto is reflected in any of the respective components.

When the component decomposition is executed in S150, control section 21 executes the deterioration abnormality prediction processing based on the cycle component (S160) and executes the accidental abnormality detection processing based on the trend component (S170). Then, control section 21 determines whether all the feed processing are completed (S180), executes the processing in and after S100 when all the feed processing are not completed, and terminates this routine when all the feed processing are completed.

Here, the deterioration abnormality prediction processing in step S160 will be described. Fig. 6 is a flowchart illustrating an example of a deterioration abnormality prediction processing routine executed by control section 21. This routine is stored in storage section 35 of feeding device 20 and is executed in S160 of the medium feed processing routine. When this routine is started, control section 21 acquires the cycle component within a predetermined period from detection information 36 (S200) and calculates a variation width of the cycle component (S210). Control section 21 sets, for example, a difference value between the maximum value and the minimum value of the cycle component obtained in every predetermined period as the deterioration abnormality level. Then, control section 21 stores the acquired variation width (difference value) in abnormality level information 37 as the deterioration abnormality level of the predetermined period, and outputs abnormality level information 37 (S220). Control section 21 may, for example, display and output the deterioration abnormality level on a display section of operation panel 28 included in processing system 10, or may output abnormality level information 37 to management device 40 to display and output the deterioration abnormality level on display section 41.

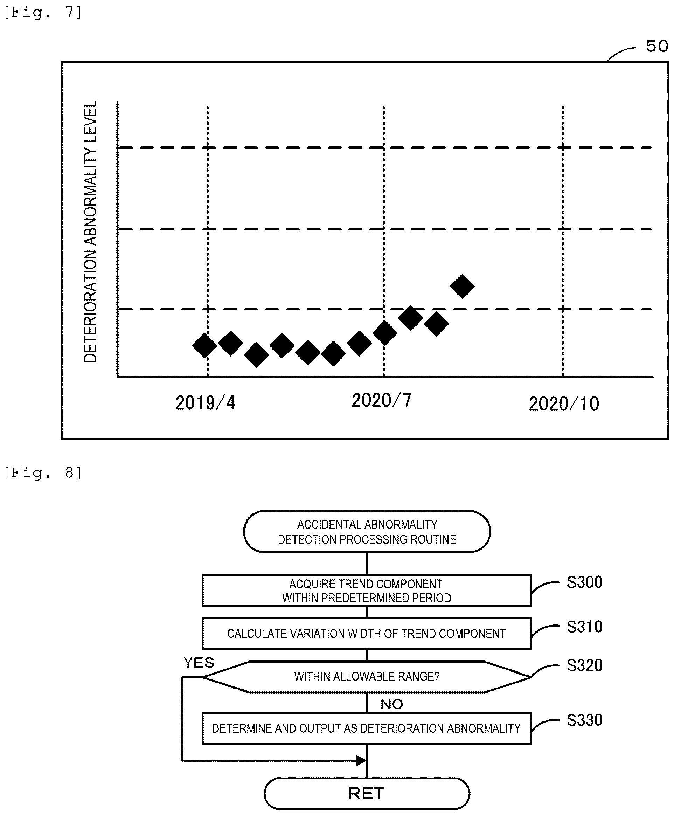

Fig. 7 is an explanatory diagram illustrating an example of abnormality level display screen 50 displayed and output on display section 41 of management device 40. Abnormality level display screen 50 indicates the chronological change of the deterioration abnormality level recorded in abnormality level information 37, in which a horizontal axis represents the time period of the predetermined period and a vertical axis represents the deterioration abnormality level. The operator can confirm abnormality level display screen 50, and determine that it is necessary to perform maintenance or the like of gear mechanism 23 when the deterioration abnormality level exceeds a predetermined threshold value or when the deterioration abnormality level significantly increases from a previous value.

After S220, control section 21 determines whether the obtained deterioration abnormality level is within a predetermined allowable range (S230) and terminates the routine when the deterioration abnormality level is within the predetermined allowable range. On the other hand, when the deterioration abnormality level is not within the predetermined allowable range, control section 21 determines that the deterioration abnormality occurs, outputs information to that effect (S240), and terminates this routine. Control section 21 may determine that the deterioration abnormality of the gear occurs when the abnormality level of the cycle component exceeds a predetermined allowable threshold value. Alternatively, control section 21 may determine that the deterioration abnormality of the gear occurs in a case where the abnormality level of the cycle component increases more than the predetermined allowable threshold value compared with the abnormality level acquired at the previous time. The allowable range and the allowable threshold value may be empirically determined, for example, in a range in which the abnormal operation of gear mechanism 23 greatly affects the feed processing of medium 12. In addition, control section 21 may display and output the occurrence of the deterioration abnormality of gear mechanism 23 on operation panel 28, or may display and output the occurrence of the deterioration abnormality of gear mechanism 23 on display section 41 of management device 40. The operator who confirms this information stops the use of gear mechanism 23 and exchanges the gear or the like.

Next, the accidental abnormality detection processing in step S170 will be described. Fig. 8 is a flowchart illustrating an example of an accidental abnormality detection processing routine executed by control section 21. This routine is stored in storage section 35 of feeding device 20 and is executed in step S170 of the medium feed processing routine. When this routine is started, control section 21 acquires the trend component within a predetermined period from detection information 36 (S300) and calculates the variation width of the trend component (S310). Control section 21 sets, for example, a difference value between the maximum value and the minimum value of the trend component obtained in every predetermined period as the accidental abnormality level. Control section 21 determines whether the obtained accidental abnormality level is within a predetermined allowable range (S320). Control section 21 may determine whether the accidental abnormality level of the trend component exceeds the predetermined allowable threshold value, thereby determining whether the accidental abnormality level of the trend component exceeds the predetermined allowable range. Alternatively, control section 21 may determine whether the accidental abnormality level of the trend component exceeds a predetermined allowable range by determining that the accidental abnormality level of the trend component increases more than the predetermined allowable threshold value compared with the abnormality level acquired at the previous time. The allowable range and the allowable threshold value may be empirically determined, for example, in a range in which predetermined processing (for example, printing processing) is greatly affected in the feed processing of medium 12. When the accidental abnormality level is within the allowable range, control section 21 terminates this routine. On the other hand, when the accidental abnormality level is not within the allowable range, control section 21 determines that the accidental abnormality occurs, outputs information to that effect (S 330), and terminates this routine. For example, control section 21 may display and output the effect that the accidental abnormality occurs on the display section of operation panel 28 or may output the effect to management device 40. The operator who has confirmed this performs, for example, maintenance of feeding device 20.

Here, a correspondence relationship between the configuration elements of the present embodiment and the configuration elements of the present disclosure will be specified. Driving section 22 of the present embodiment corresponds to the driving section of the present disclosure, first gear 24 and second gear 25 of gear mechanism 23 correspond to the gear, detection section 38 corresponds to the detection section, control section 21 corresponds to the control section, feeding device 20 corresponds to the feeding device, and abnormality prediction device 30 corresponds to the abnormality prediction device. In the present embodiment, an example of the abnormality prediction method of the present disclosure is also clarified by explaining the operation of abnormality prediction device 30.

In abnormality prediction device 30 of the present embodiment described above, detection information 36 regarding the feed amount of the medium based on the position of medium 12 detected over time is decomposed into the trend component regarding the moving average of the gears of gear mechanism 23, the cycle component based on the cycle of the gears, and the random component obtained by excluding the trend component and the cycle component. Then, abnormality prediction device 30 obtains the deterioration abnormality level of the gear based on the cycle component obtained by the decomposition, and outputs the obtained deterioration abnormality level to management device 40. Since the cycle component obtained by decomposing detection information 36 is a component strongly affected by, for example, deterioration or wear of the gear, it is possible to more appropriately predict the abnormality of the gear.

In addition, control section 21 obtains a difference value between the maximum value and the minimum value of the cycle component in every predetermined period as the deterioration abnormality level. Since the value of the cycle component changes depending on the rotation cycle of the gear, abnormality prediction device 30 can more appropriately predict the abnormality of the gear by using the difference value of the cycle component. Further, control section 21 stores, as detection information 36, the position of medium 12 detected by detection section 38, the actual measurement value of the feed amount obtained based on the position of medium 12, and the error between the feed amount per step of intermittently feeding medium 12 and the actual measurement value which are associated with the time when the position of medium 12 is detected. In abnormality prediction device 30, the cycle component can be decomposed by using the position of medium 12, the actual measurement value of the feed amount, the error of the feed amount, and the like. Furthermore, control section 21 may obtain the accidental abnormality level of the gear based on the chronological change of the trend component obtained by the decomposition. In abnormality prediction device 30, it is possible to more appropriately predict the abnormality regarding the gear also by using components other than the cycle component. In addition, control section 21 obtains the difference value between the maximum value and the minimum value of the trend component as the accidental abnormality level in every predetermined period. Since the maximum value and the minimum value of the trend component may be caused by the accidental abnormality of the gear, abnormality prediction device 30 can more appropriately predict the abnormality of the gear by using the difference value of the trend component.

It goes without saying that the present disclosure is not limited to the embodiments described above and can be implemented in various aspects as long as it is within the limits as defined by the appended claims.

For example, in the above embodiments, the difference value between the maximum value and the minimum value of the cycle component is obtained as the deterioration abnormality level in every predetermined period, however, the present invention is not particularly limited to this as long as the cycle component is used. For example, the amplitude value of the cycle component for each step within a predetermined period may be obtained, and the average value may be used as the deterioration abnormality level. Even in this abnormality prediction device, it is possible to more appropriately predict the abnormality of the gear by using the cycle component.

In the embodiments described above, detection information 36 includes the position of medium 12, the actual measurement value of the feed amount, and the error of the feed amount, however, the configuration is not limited to these, and may include one or more of these. If there is any of these, control section 21 can obtain the deterioration abnormality level.

In the embodiments described above, the deterioration abnormality is determined and displayed and output when the deterioration abnormality level exceeds a predetermined allowable range, however, the present invention is not particularly limited to this, and the determination processing of the deterioration abnormality may be omitted. The operator can also determine a situation of the deterioration abnormality, for example, by confirming the contents of abnormality level display screen 50 and abnormality level information 37. In the embodiments described above, although the accidental abnormality is determined, displayed, and output when the accidental abnormality level exceeds the predetermined allowable range, however, the present invention is not particularly limited to this, and the determination processing of the accidental abnormality may be omitted. For example, assuming that control section 21 stores data of the accidental abnormality level or the like in storage section 35, the operator can also determine the situation of the accidental abnormality by confirming the contents thereof.

In the embodiments described above, the difference value between the maximum value and the minimum value of the trend component is obtained as the accidental abnormality level in every predetermined period, however, the present invention is not particularly limited to this as long as the trend component is used. For example, the amplitude of the trend component may be obtained, and the average may be used as the accidental abnormality level. Also in abnormality prediction device 30, it is possible to detect the abnormality of feeding device 20 by using the trend component. Alternatively, in the embodiments described above, control section 21 obtains the accidental abnormality level of the gear based on the trend component, however, the present invention is not particularly limited to this, and this processing may be omitted. Also in abnormality prediction device 30, since the deterioration abnormality level is determined by using the cycle component, it is possible to more appropriately predict the abnormality of the gear.

In the embodiments described above, gear mechanism 23 has first gear 24 and second gear 25, however, the present invention is not particularly limited to this, and may further include one or more gears other than these. Control section 21 may separate the cycle component from each gear.

Although the embodiments are described as providing the function of the abnormality prediction device of the present disclosure in feeding device 20, however, the present disclosure is not particularly limited to this, and may be configured to have the function of the abnormality prediction device of the present disclosure in an external device such as management device 40.

In the embodiments described above, the present disclosure is described as abnormality prediction device 30, however, the present disclosure is not particularly limited to this, and may be an abnormality prediction method, or may be a program in which the abnormality prediction method executed by a computer.

### [Industrial Applicability]

The abnormality prediction device, the feeding device, and the abnormality prediction method of the present disclosure can be used in a field of mounting regarding a method of detecting and predicting an abnormality of a machine that feeds a member by a gear.

### Reference Signs List

10 processing system, 12 medium, 20 feeding device, 21 control section, 22 driving section, 23 gear mechanism, 24 first gear, 25 second gear, 26 feeding member, 27 communication section, 28 operation panel, 30 abnormality prediction device, 31 information acquisition section, 32 component decomposition section, 33 cycle component processing section, 34 trend component processing section, 35 storage section, 36 detection information, 37 abnormality level information, 38 detection section, 40 management device, 41 display section, 42 input device, 50 abnormality display screen.

## Claims

1. An abnormality prediction device (30) configured to be used in a feeding device (20) including a driving section (22), a gear (23) connected to the driving section (22), and a detection section (38) configured to detect a position of a medium (12) fed in accordance with driving of the gear (23), and intermittently feeding the medium (12), the abnormality prediction device (30) comprising:
a control section (21) configured to acquire detection information regarding a feed amount of the medium (12) based on the position of the medium (12) detected over time by the detection section (38),
**characterized in that**
the control section (21) is configured to decompose the acquired detection information into a trend component regarding a moving average of the gear (23), a cycle component based on a cycle of the gear (23), and a random component obtained by excluding the trend component and the cycle component, obtain an abnormality level of the gear (23) based on the cycle component obtained by the decomposition, and output the obtained abnormality level.

2. The abnormality prediction device (30) according to Claim 1,
wherein the control section (21) is configured to obtain a difference value between a maximum value and a minimum value of the cycle component in each predetermined period as the abnormality level.

3. The abnormality prediction device (30) according to Claim 1 or 2,
wherein the control section (21) is configured to acquire the detection information in which one or more of the position of the medium (12) detected by the detection section (38), an actual measurement value of the feed amount obtained based on the position of the medium (12), and an error between the actual measurement value and a feed amount per step of intermittently feeding the medium (12) is associated with a time when the position of the medium (12) is detected.

4. The abnormality prediction device (30) according to any one of Claims 1 to 3,
wherein the control section (21) is configured to obtain an accidental abnormality level of the gear (23) based on a chronological change of the trend component obtained by the decomposition.

5. The abnormality prediction (30) device according to Claim 4,
wherein the control section (21) is configured to obtain a difference value between a maximum value and a minimum value of the trend component in each predetermined period as the accidental abnormality level.

6. A feeding device (20) comprising:
a driving section (22);
a gear (23) connected to the driving section (22);
a detection section (38) configured to detect a position of a medium (12) fed in accordance with driving of the gear (23); and
the abnormality prediction device (30) according to any one of Claims 1 to 5.

7. An abnormality prediction method executed by a computer and used in a feeding device (20) which includes a driving section (22), a gear (23) connected to the driving section (22), and a detection section (38) configured to detect a position of a medium (12) fed in accordance with driving of the gear (23), and intermittently feeds the medium (12), the abnormality prediction method comprising:
a) a step of acquiring (S110) detection information regarding a feed amount of the medium (12) based on the position of the medium (12) detected over time by the detection section (38);
**characterized by**
b) a step of decomposing (S150) the detection information acquired in the step a) into a trend component regarding a moving average of the gear (23), a cycle component based on a cycle of the gear (23), and a random component obtained by excluding the trend component and the cycle component; and
c) a step of obtaining (S160) an abnormality level of the gear (23) based on the cycle component obtained by the decomposition in the step b).

## Patentansprüche

1. Vorrichtung (30) zur Vorhersage von Anomalien, die so konfiguriert ist, dass sie in einer Zuführvorrichtung (20) verwendet werden kann, die einen Antriebsabschnitt (22), ein mit dem Antriebsabschnitt (22) verbundenes Getriebe (23) und einen Erfassungsabschnitt (38) enthält, der so konfiguriert ist, dass er eine Position eines Mediums (12) erfasst, das in Übereinstimmung mit dem Antrieb des Getriebes (23) zugeführt wird, und das Medium (12) intermittierend zuführt, wobei die Vorrichtung (30) zur Vorhersage von Anomalien Folgendes umfasst:
einen Steuerabschnitt (21), der so konfiguriert ist, dass er Erfassungsinformationen bezüglich einer Zuführungsmenge des Mediums (12) auf der Grundlage der Position des Mediums (12), die im Laufe der Zeit durch den Erfassungsabschnitt (38) erfasst wird, erfasst
**dadurch gekennzeichnet, dass**
der Steuerabschnitt (21) so konfiguriert ist, dass er die erfasste Erfassungsinformation in eine Trendkomponente, die einen gleitenden Durchschnitt des Zahnrads (23) betrifft, eine Zykluskomponente, die auf einem Zyklus des Getriebes (23) basiert, und eine Zufallskomponente, die durch Ausschluss der Trendkomponente und der Zykluskomponente erhalten wird, zerlegt, einen Abnormitätspegel des Getriebes (23) basierend auf der durch die Zerlegung erhaltenen Zykluskomponente erhält und den erhaltenen Abnormitätspegel ausgibt.

2. Vorrichtung (30) zur Vorhersage von Anomalien nach Anspruch 1,
wobei der Steuerabschnitt (21) so konfiguriert ist, dass er einen Differenzwert zwischen einem Maximalwert und einem Minimalwert der Zykluskomponente in jeder vorbestimmten Periode als den Abnormitätspegel erhält.

3. Vorrichtung (30) zur Vorhersage von Anomalien nach Anspruch 1 oder 2,
wobei der Steuerabschnitt (21) so konfiguriert ist, dass er die Erfassungsinformationen erfasst, in denen eine oder mehrere Positionen des Mediums (12), die von dem Erfassungsabschnitt (38) erfasst werden, ein tatsächlicher Messwert der Vorschubmenge, der auf der Grundlage der Position des Mediums (12) erhalten wird, und ein Fehler zwischen dem tatsächlichen Messwert und einer Vorschubmenge pro Schritt des intermittierenden Vorschubs des Mediums (12) mit einer Zeit verknüpft ist, zu der die Position des Mediums (12) erfasst wird.

4. Vorrichtung (30) zur Vorhersage von Anomalien nach einem der Ansprüche 1 bis 3,
wobei der Steuerabschnitt (21) so konfiguriert ist, dass er ein zufälliges Abnormitätsniveau des Zahnrads (23) auf der Grundlage einer chronologischen Änderung der durch die Zerlegung erhaltenen Trendkomponente erhält.

5. Vorrichtung zur Vorhersage von Anomalien (30) nach Anspruch 4,
wobei der Steuerabschnitt (21) so konfiguriert ist, dass er einen Differenzwert zwischen einem Maximalwert und einem Minimalwert der Trendkomponente in jeder vorbestimmten Periode als das Niveau der zufälligen Abnormalität erhält.

6. Zuführvorrichtung (20), umfassend:
einen Antriebsabschnitt (22);
ein Getriebe (23), das mit dem Antriebsabschnitt (22) verbunden ist
einen Erfassungsabschnitt (38), der so konfiguriert ist, dass er eine Position eines Mediums (12) erfasst, das in Übereinstimmung mit dem Antrieb des Zahnrads (23) zugeführt wird; und
die Vorrichtung zur Vorhersage von Anomalien (30) nach einem der Ansprüche 1 bis 5.

7. Verfahren zur Vorhersage von Anomalien, das von einem Computer ausgeführt und in einer Zuführvorrichtung (20) verwendet wird, die einen Antriebsabschnitt (22), ein mit dem Antriebsabschnitt (22) verbundenes Getriebe (23) und einen Erfassungsabschnitt (38) enthält, der so konfiguriert ist, dass er eine Position eines entsprechend dem Antrieb des Getriebes (23) zugeführten Mediums (12) erfasst, und das Medium (12) intermittierend zuführt, wobei das Verfahren zur Vorhersage von Anomalien Folgendes umfasst:
a) einen Schritt des Erfassens (S110) von Erfassungsinformationen bezüglich einer Zuführmenge des Mediums (12) auf der Grundlage der Position des Mediums (12), die über die Zeit durch den Erfassungsabschnitt (38) erfasst wird;
**gekennzeichnet durch**
b) einen Schritt des Zerlegens (S150) der im Schritt a) gewonnenen Erfassungsinformation in eine Trendkomponente, die einen gleitenden Durchschnitt des Getriebes (23) betrifft, eine Zykluskomponente, die auf einem Zyklus des Getriebes (23) basiert, und eine Zufallskomponente, die durch Ausschluss der Trendkomponente und der Zykluskomponente erhalten wird; und
c) einen Schritt des Erhaltens (S160) eines Abnormitätsniveaus des Getriebes (23) basierend auf der Zykluskomponente, die durch die Zerlegung im Schritt b) erhalten wird.

## Revendications

1. Dispositif de prédiction d'anomalie (30) configuré pour être utilisé dans un dispositif d'alimentation (20) incluant une section d'entraînement (22), un engrenage (23) connecté à la section d'entraînement (22) et une section de détection (38) configurée pour détecter une position d'un support (12) fourni conformément à un entraînement de l'engrenage (23), et fournissant de manière intermittente le support (12), le dispositif de prédiction d'anomalie (30) comprenant :
une section de contrôle (21) configurée pour acquérir des informations de détection relatives à une quantité d'alimentation du support (12) selon la position du support (12) détectée au fil du temps par la section de détection (38),
**caractérisé en ce que**
la section de contrôle (21) est configurée pour décomposer les informations de détection acquises en une composante de tendance relative à une moyenne de mouvement de l'engrenage (23), une composante de cycle s'appuyant sur un cycle de l'engrenage (23) et une composante aléatoire obtenue en excluant la composante de tendance et la composante de cycle, obtenir un niveau d'anomalie de l'engrenage (23) selon la composante de cycle obtenue par la décomposition, et produire en sortie le niveau d'anomalie obtenu.

2. Le dispositif de prédiction d'anomalie (30) selon la revendication 1,
dans lequel la section de contrôle (21) est configurée pour obtenir une valeur de différence entre une valeur maximale et une valeur minimale de la composante de cycle dans chaque période prédéterminée en tant que niveau d'anomalie.

3. Le dispositif de prédiction d'anomalie (30) selon la revendication 1 ou 2,
dans lequel la section de contrôle (21) est configurée pour acquérir des informations de détection dans lesquelles une ou plusieurs de la position du support (12) détectée par la section de détection (38), une valeur de mesure réelle de la quantité d'alimentation obtenue selon la position du support (12), et une erreur entre la valeur de mesure réelle et une quantité d'alimentation par pas de fourniture intermittente du support (12) sont associées à un moment où la position du support (12) est détectée.

4. le dispositif de prédiction d'anomalie (30) selon l'une quelconque des revendications 1 à 3,
dans lequel la section de contrôle (21) est configurée pour obtenir un niveau d'anomalie accidentelle de l'engrenage (23) selon une modification chronologique de la composante de tendance obtenue par la décomposition.

5. Le dispositif de prédiction d'anomalie (30) selon la revendication 4,
dans lequel la section de contrôle (21) est configurée pour obtenir une valeur de différence entre une valeur maximale et une valeur minimale de la composante de tendance dans chaque période prédéterminée en tant que niveau d'anomalie accidentelle.

6. Dispositif d'alimentation (20) comprenant :
une section d'entraînement (22) ;
un engrenage (23) connecté à la section d'entraînement (22) ;
une section de détection (38) configurée pour détecter une position d'un support (12) fourni conformément à un entraînement de l'engrenage (23) ; et
le dispositif de prédiction d'anomalie (30) selon l'une quelconque des revendications 1 à 5.

7. Procédé de prédiction d'anomalie exécuté par un ordinateur et utilisé dans un dispositif d'alimentation (20) qui inclut une section d'entraînement (22), un engrenage (23) connecté à la section d'entraînement (22) et une section de détection (38) configurée pour détecter une position d'un support (12) fourni conformément à un entraînement de l'engrenage (23), et fournissant de manière intermittente le support (12), le procédé de prédiction d'anomalie comprenant :
a) une étape d'acquisition (110) d'informations de détection relatives à une quantité d'alimentation du support (12) selon la position du support (12) détectée au fil du temps par la section de détection (38) ;
**caractérisé par**
b) une étape de décomposition (S150) des informations de détection acquises à l'étape a) en une composante de tendance relative à une moyenne de mouvement de l'engrenage (23), une composante de cycle s'appuyant sur un cycle de l'engrenage (23) et une composante aléatoire obtenue en excluant la composante de tendance et la composante de cycle ; et
c) une étape d'obtention (S160) d'un niveau d'anomalie de l'engrenage (23) selon la composante de cycle obtenue par la décomposition à l'étape b).
